# EUROPEAN PATENT APPLICATION

(11) **EP 4 625 500 A1**
(43) Date of publication of application: **01.10.2025**
(21) Application number: 24167127.0
(22) Date of filing: 28.03.2024
(51) Int. Cl.: H01L 31/0224, H01L 31/068

(54) **METHOD OF FORMING A PHOTOVOLTAIC DEVICE AND THE PHOTOVOLTAIC DEVICE**

(71) Applicant: Imec VZW, 3001 Leuven (BE); Universiteit Hasselt, 3500 Hasselt (BE)
(72) Inventor: BORGERS, Tom, 4000 Liège (BE); SIVARAMAKRISHNAN RADHAKRISHNAN, Hariharsudan, 3051 SInt-Joris-Weert (BE)
(74) Representative: Winger

(57) **Abstract**

A method of forming a photovoltaic device (6) comprising a plurality of electrically interconnected back-contact photovoltaic cell pieces (13) comprises:
i) obtaining a back-contact photovoltaic cell (1) comprising an array of sections (10) logically organised in rows and columns, each section (10) comprising, at a backside (11) of the cell (1), at least one first contact (21) of a first polarity and at least one second contact (22) of a second polarity, opposite to the first polarity,
ii) attaching, to said backside (11), a cell-level interconnection sheet (3) comprising:
an insulating carrier sheet (30), and
a plurality of conductive wires (31, 32), comprising parallel interconnects (31), and
serial interconnects (32), and

iii) partitioning the photovoltaic cell (1) into a plurality of physically separated cell pieces (13),
wherein said attaching and said partitioning are performed so that the cell pieces (13) in each row are connected in parallel by the parallel interconnects (31), and the cell pieces (13) in each column are interconnected in series by the serial interconnects (32).

## Description

### Technical field of the invention

The present invention relates to the field of photovoltaic devices and more specifically to a method for interconnecting back-contact photovoltaic cell pieces and a device that may be formed by said method.

### Background of the invention

The field of photovoltaic (PV) technology has seen significant advancements over the years, with a focus on increasing the efficiency of solar cells and the overall energy conversion rates of solar panels. One of the key areas of innovation has been in the design and manufacturing of back-contact solar cells, which offer the advantage of having both positive and negative contacts on the rear side of the cell. Back-contact solar cells may eliminate the need for front-side electrical interconnections or front-side metallization, thereby reducing shading on the cell surface and potentially increasing the cell's efficiency, as well as reducing the amount of material required, thus reducing costs.

In the realm of Building-Integrated Photovoltaics (BIPV) and Vehicle-Integrated Photovoltaics (VIPV), the integration of solar cells into various surfaces and structures presents unique challenges. BIPV modules, in particular, are expected to not only generate power but also to aesthetically blend with building architecture, requiring custom designs and flexible manufacturing processes. However, the production of BIPV modules often lacks vertical integration, leading to a dependency of module manufacturers on cell manufacturers to supply cells tailored for specific interconnection technologies.

The current interconnection technologies, such as tabbing and stringing or Conductive Back Sheet (CBS) technology, require significant investments in production tools and are not always compatible with the latest cell technologies. These methods also impose limitations on the flexibility of solar cell connections, which can be a hindrance when creating custom-made BIPV modules. Additionally, the increasing demand for shade-resistant and smart BIPV and VIPV modules poses further challenges to existing module interconnection approaches.

Another issue faced in the field is the extra requirements related to cell technology, such as limited temperature budgets, specific metallization types, and the integration of tandem cells. These factors further constrain the tolerances and flexibility of cell interconnection technologies and PV production methods.

The ever-increasing size of solar cells, such as M10 and M12 formats, leads to higher interconnection costs as the cross-sectional area of conductors must be increased to handle the larger currents. While the industry has adopted methods like shingling and half-cut cells to manage these issues, these approaches add complexity and cost to the manufacturing process and increase the risk of cell breakage during handling.

Despite the progress made in PV technology, there remains a need for further advancements that can provide more independence from the rapidly evolving PV cell and interconnection technology roadmaps. Such advancements should also offer greater flexibility in the production of BIPV modules and allow for the cell-level integration of passive elements or electronic components. The industry continues to seek solutions that can optimize cost and performance while minimizing investment risks and enhancing process reliability for module manufacturers.

There is thus still a need in the art for devices and methods that address at least some of the above problems.

### Summary of the invention

It is an object of the present invention to provide a good method for interconnecting back-contact photovoltaic cell pieces. It is an object of the present invention to provide a good photovoltaic device comprising interconnected back-contact photovoltaic cell pieces. It is a further object of the present invention to provide a good module comprising a plurality of said photovoltaic devices.

The above objective is accomplished by a method, photovoltaic device and module according to embodiments of the present invention.

It is an advantage of embodiments of the present invention that the method may be efficient and may be performed in only a limited number of steps. It is an advantage of embodiments of the present invention that interconnecting the contacts of a back-contact photovoltaic cell may be efficiently performed. It is, in particular, an advantage of embodiments of the present invention that the number of steps of alignment - which may be a time-consuming step that is prone to alignment errors - may be limited.

It is an advantage of embodiments of the present invention that a photovoltaic device for curved surfaces may be manufactured using techniques that may be straightforward to apply.

It is an advantage of embodiments of the present invention that, as both parallel and series interconnects are provided, the effect of shading - by, e.g., clouds or objects proximate to the photovoltaic device -on the power generation by the photovoltaic device is limited as strictly as possible to the shaded area on the photovoltaic device. It is a further advantage of embodiments of the present invention that the thickness of the conductive wires may be limited without compromising the fill factor. It is, therefore, an advantage of embodiments of the present invention that the amount of material that may be used is limited, so that the costs for materials may be low. It is a further advantage of embodiments of the present invention that the shading by wires of the backside of the photovoltaic device - which may be particularly relevant for double-sided irradiation - may be limited.

In a first aspect, the present invention relates to a method of forming a photovoltaic device comprising a plurality of electrically interconnected back-contact photovoltaic cell pieces. The method comprises a step i) of obtaining a back-contact photovoltaic cell comprising an array of sections logically organised in rows and columns, each section comprising, at a backside of the cell, at least one first contact of a first polarity and at least one second contact of a second polarity, opposite to the first polarity. The method comprises a step ii) of attaching, to said backside, a cell-level interconnection sheet comprising an insulating carrier sheet, and a plurality of conductive wires. The plurality of conductive wires comprise parallel interconnects arranged to electrically couple, within each row of the array, the first contacts to each other, and serial interconnects arranged to electrically couple, within each column of the array, for each pair of adjacent sections, the parallel interconnect connected to the first contacts of a section of the pair to the second contact of an adjacent section of the pair, wherein each serial interconnect is electrically interrupted between the second contact of each section and the parallel interconnect connected to the first contacts of said section. The method further comprises a step iii) of partitioning the photovoltaic cell into a plurality of physically separated cell pieces. Said attaching and said partitioning are performed so that the cell pieces in each row are connected in parallel by the parallel interconnects, and the cell pieces in each column are interconnected in series by the serial interconnects.

In preferred embodiments, step ii is performed before step iii, so that said partitioning may comprise partitioning the cell directly into a plurality of physically separated but electrically interconnected cell pieces. In these embodiments, the cell-level interconnection sheet supports the cell pieces after said partitioning.

In some embodiments, step ii may be performed after step iii. In these embodiments, typically, before step iii, a transparent sheet (different from the cell-level interconnection sheet) is connected to the frontside of the photovoltaic cell. In these embodiments, after said partitioning, the cell pieces are supported by said transparent sheet, and the cell-level interconnection sheet may be attached to the cell pieces supported by the transparent sheet. Said transparent sheet may hold the cell pieces in place or aligned, so that the subsequent alignment and attachment of the cell-level interconnection sheet to the cell pieces may be facilitated.

The cell pieces typically correspond to said sections after partitioning. The sections, before said partitioning, may be physically distinguishable from each other, but that is not necessary, and the back-contact photovoltaic cell may be substantially uniform. Typically, each section may be a part of the back-contact photovoltaic cell that forms, after said partitioning in step iii), a cell piece.

In embodiments, partitioning the photovoltaic cell may comprise cutting the photovoltaic cell so as to physically separate the sections from each other, thereby obtaining an array of back-contact photovoltaic cell pieces. When the cell-level interconnection sheet is attached to the backside of the cell before said partitioning, said partitioning is typically performed from a frontside of the cell. When the transparent sheet is attached to the frontside cell before said partitioning, said partitioning is typically performed from a backside of the cell. It is an advantage of these embodiments that a predictable and reproducible physical separation between the cell pieces may be obtained. However, said partitioning may be performed in any way known to the skilled person. In embodiments, before applying the cell-level interconnection sheet or the transparent sheet (before said partitioning), a groove may be formed by thinning the back-contact photovoltaic cell in between the sections, e.g., by cutting or etching, and the partitioning may comprise applying a force so as to break the sections from each other by breaking the back-contact photovoltaic cell at said groove.

In embodiments, said cutting may be performed by laser scribing. It is an advantage of these embodiments that an accurate and clean technique for cutting the cell into pieces may be obtained. In embodiments, said cutting may be performed by saw scribing. In embodiments, said cutting comprises thermal laser separation (TLS) dicing.

In embodiments wherein the cell-level interconnection sheet is attached before said partitioning, the method may further comprise, after step iii), a step iv) of attaching said transparent sheet to a frontside of the plurality of cell pieces. It is an advantage of the transparent sheet that additional mechanical support and protection for the cell pieces may be provided. Said sheet may comprise an adhesive functionality on the side of the sheet contacting the frontside of the plurality of cell pieces.

In embodiments wherein the cell-level interconnection sheet is attached before said partitioning, the method may comprise, before step ii), a step ii') of preforming the cell-level interconnection sheet by positioning the cell-level interconnection sheet on a vacuum mould comprising a plurality of trenches, and applying a vacuum into the trenches to form corresponding deformations into the cell-level interconnection sheet, wherein, in step ii), the photovoltaic cell is attached to the preformed cell-level interconnection sheet so that said deformations in the cell-level interconnection sheet are located between, e.g. at a border between, adjacent sections of the photovoltaic cell, wherein, in step iii), the sections are split at the deformations in the preformed cell-level interconnection sheet. After said splitting, the deformation may be relaxed and flattened, which may result in a gap between the cell pieces. It is an advantage of these embodiments that the gap may prevent physical or electric contact between the cell pieces. Said electric contact could result in unwanted electrical connections between the cell pieces or even short-circuit in the device that is formed by the method. It is an advantage of these embodiments that the alignment of the cell pieces with respect to each other may be accurate and reproducible.

In embodiments wherein the transparent sheet is attached before said partitioning, instead, the transparent sheet may be preformed. In these embodiments, the method may comprise positioning the transparent sheet on the vacuum mould comprising a plurality of trenches, and applying a vacuum into the trenches to form corresponding deformations into the transparent sheet, wherein, in step ii), the photovoltaic cell is attached to the preformed transparent sheet so that said deformations in the transparent sheet are located between, e.g. at a border between, adjacent sections of the photovoltaic cell, wherein, in step iii), the sections are split at the deformations in the preformed transparent sheet. After said splitting, the deformation may be relaxed and flattened, which may result in a gap between the cell pieces.

In a second aspect, the present invention relates to a photovoltaic device. The photovoltaic device comprises an array of physically separated back-contact photovoltaic cell pieces logically organised in rows and columns, each photovoltaic cell piece comprising, at a backside thereof, at least one first contact of a first polarity and at least one second contact of a second polarity, opposite to the first polarity. The photovoltaic device further comprises an interconnection sheet, attached to said backside of the array of photovoltaic cell pieces. The interconnection sheet comprises an insulating carrier sheet for supporting the array of cell pieces, and a plurality of conductive wires. The plurality of conductive wires comprise parallel interconnects arranged to electrically couple, within each row of the array, the first contacts to each other, so that the cell pieces in each row are connected in parallel by the parallel interconnects. The plurality of conductive wires further comprise serial interconnects arranged to electrically couple, within each column of the array, for each pair of adjacent pieces, the parallel interconnect connected to the first contact of a cell piece of the pair to the second contact of an adjacent cell piece of the pair (within the same column), wherein each serial interconnect is electrically interrupted between the second contact of each cell piece and the parallel interconnect connected to the first contacts of said cell piece, so that the cell pieces in each column are interconnected in series by the serial interconnects.

The interconnects may be formed of any electrically conductive material, such as a metal, carbon, graphene, or conductive polymer. In embodiments, each serial interconnect is arranged so that a direction from the parallel interconnect to the second contact the serial interconnect is connected to, is substantially the same for the different serial interconnects. In other words, each serial interconnect is arranged so that a direction from each cell piece to each said adjacent cell piece, interconnected by the serial interconnect, is substantially the same for the different serial interconnects. In these embodiments, the voltage generated in the subsequent rows may add up so that the total voltage generated by the device may build up along the column.

The parallel interconnects may ensure that a voltage at first contacts within a same row may be substantially the same. The parallel interconnects may ensure that a voltage at second contacts within a same row may be substantially the same.

In embodiments, the interconnection sheet may comprise a first lateral edge contact at a corner cell piece, located at a corner of the array, wherein the first lateral edge contact extends off the cell pieces, wherein the first lateral edge contact is electrically coupled to a parallel interconnect of the row containing said corner cell piece. It is an advantage of these embodiments that interconnection between different photovoltaic devices may be facilitated.

In embodiments, the interconnection sheet may contain a second lateral edge contact at said corner cell piece, extending off the cell pieces, and electrically coupled to an interconnect connected to the parallel interconnect connected to the first contacts of said corner cell piece. The first lateral edge contact may extend off the cell pieces in a direction along which each row is oriented. The second lateral edge contact may extend off the cell pieces in a direction along which each column is oriented. It is an advantage of these embodiments that interconnection between different photovoltaic devices may be facilitated. It is an advantage of these embodiments that freedom may be achieved on how to interconnect the photovoltaic devices. Preferably, the photovoltaic device comprises both the first and second lateral edge contact. However, instead, the photovoltaic device may comprise the first lateral edge contact or the second lateral edge contact.

In embodiments, the photovoltaic device may comprise parallel interconnects extending on a first side, attached to the photovoltaic cell pieces, of the interconnection sheet, and serial interconnects extending on a second side, opposite to the first side, of the interconnection sheet, wherein the interconnection sheet comprises a further parallel interconnect, oriented parallel to the parallel interconnects, on the first side of the interconnection sheet, wherein the interconnection sheet is folded back at a first edge of the photovoltaic device different from a second edge containing a lateral edge contact, thereby exposing the further parallel interconnect for making further electrical connections. Said exposed further parallel interconnect may be contacted by the first or second lateral edge contact of another photovoltaic device. Said contacting may be straightforward, facilitating interconnecting a plurality of photovoltaic devices with each other.

In embodiments, the back-contact photovoltaic cell pieces may be metal wrap through type photovoltaic cell pieces or interdigitated back contact photovoltaic cell pieces. In embodiments, the back-contact photovoltaic cell pieces may be 2-terminal tandem photovoltaic cell pieces.

The insulating carrier sheet comprises an electrically insulating material for preventing electrical contact between the interconnects via the insulating carrier sheet. The insulating carrier sheet may comprise, or consists of, a polymer film, such as an encapsulant film. In embodiments, the insulating carrier sheet may comprise an electrically insulating polymer film with an adhesive functionality on both sides.

In a third aspect, the present invention relates to a photovoltaic module comprising a plurality of photovoltaic devices in accordance with to embodiments of the second aspect of the present invention.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

FIG. 1A and FIG. 1B are a schematical representation of a backside view and a cross-sectional view, respectively, of a metal wrap through-type back-contact photovoltaic cell in accordance with embodiments of the present invention.
FIG. 2A and FIG. 2B are a schematical representation of a backside view and a cross-sectional view, respectively, of a back-contact photovoltaic cell attached to a cell-level interconnection sheet in accordance with embodiments of the present invention.
FIG. 3A and FIG. 3B are a schematical representation of a backside view and a cross-sectional view, respectively, of a back-contact photovoltaic cell attached to a cell-level interconnection sheet, of which part is folded back, in accordance with embodiments of the present invention.
FIG. 4 to 10 are schematical representations of a cross-sectional view of a back-contact photovoltaic cell in subsequent steps in a method for forming a photovoltaic device in accordance with embodiments of the present invention.
FIG. 11 is a backside view of a photovoltaic device in accordance with embodiments of the present invention.
FIG. 12 is a backside view of a photovoltaic module in accordance with embodiments of the present invention.
FIG. 13 is a backside view of an interdigitated back contact type photovoltaic module in accordance with embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

The terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still cooperate or interact with each other.

The terms "column" and "row" are used to describe sets of photovoltaic cell sections which are linked together. The linking can be in the form of a Cartesian array of rows and columns, however, the present invention is not limited thereto. As will be understood by those skilled in the art, columns and rows can be easily interchanged and it is intended in this disclosure that these terms be interchangeable. Also, non-Cartesian arrays may be constructed and are included within the scope of the invention. Accordingly the terms "row" and "column" should be interpreted widely. To facilitate in this wide interpretation, there may be referred to "logically organised rows and columns". By this is meant that sets of photovoltaic cell sections are linked together in a topologically linear intersecting manner; however, that the physical or topographical arrangement need not be so.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In a first aspect, the present invention relates to a method of forming a photovoltaic device comprising a plurality of electrically interconnected back-contact photovoltaic cell pieces. The method comprises a step i) of obtaining a back-contact photovoltaic cell comprising an array of sections logically organised in rows and columns, each section comprising, at a backside of the cell, at least one first contact of a first polarity and at least one second contact of a second polarity, opposite to the first polarity. The method comprises a step ii) of attaching, to said backside, a cell-level interconnection sheet comprising an insulating carrier sheet, and a plurality of conductive wires. The plurality of conductive wires comprise parallel interconnects arranged to electrically couple, within each row of the array, the first contacts to each other, and serial interconnects arranged to electrically couple, within each column of the array, for each pair of adjacent sections, the parallel interconnect connected to the first contacts of a section of the pair to the second contact of an adjacent section of the pair, wherein each serial interconnect is electrically interrupted between the second contact of each section and the parallel interconnect connected to the first contacts of said section. The method further comprises a step iii) of partitioning the photovoltaic cell into a plurality of physically separated cell pieces. Said attaching and said partitioning are performed so that the cell pieces in each row are connected in parallel by the parallel interconnects, and the cell pieces in each column are interconnected in series by the serial interconnects.

In a second aspect, the present invention relates to a photovoltaic device. The photovoltaic device comprises an array of physically separated back-contact photovoltaic cell pieces logically organised in rows and columns, each photovoltaic cell piece comprising, at a backside thereof, at least one first contact of a first polarity and at least one second contact of a second polarity, opposite to the first polarity. The photovoltaic device further comprises an interconnection sheet, attached to said backside of the array of photovoltaic cell pieces. The interconnection sheet comprises an insulating carrier sheet for supporting the array of cell pieces, and a plurality of conductive wires. The plurality of conductive wires comprise parallel interconnects arranged to electrically couple, within each row of the array, the first contacts to each other, so that the cell pieces in each row are connected in parallel by the parallel interconnects. The plurality of conductive wires further comprise serial interconnects arranged to electrically couple, within each column of the array, for each pair of adjacent pieces, the parallel interconnect connected to the first contact of a cell piece of the pair to the second contact of an adjacent cell piece of the pair (within the same column), wherein each serial interconnect is electrically interrupted between the second contact of each cell piece and the parallel interconnect connected to the first contacts of said cell piece, so that the cell pieces in each column are interconnected in series by the serial interconnects.

### Example 1: Attaching a cell-level interconnection sheet to a metal wrap through-type back-contact photovoltaic cell

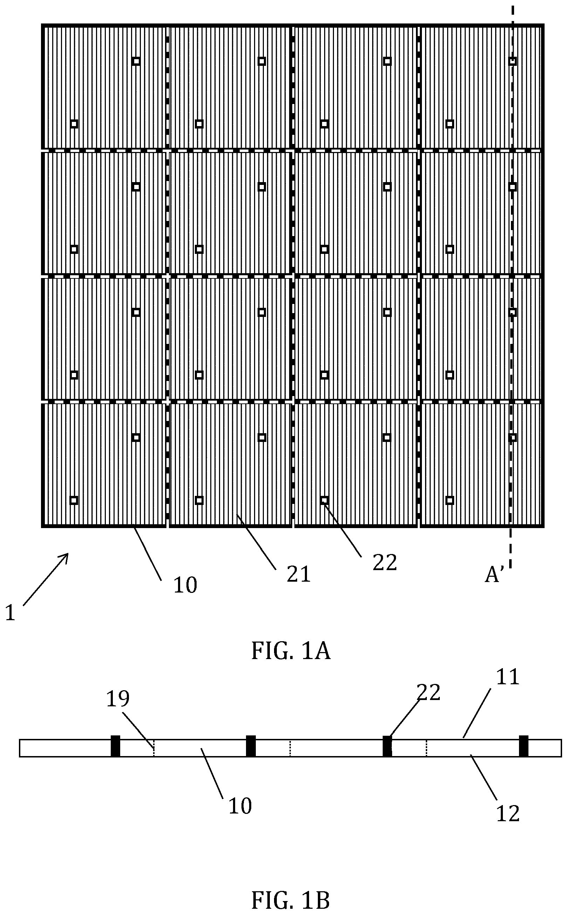

Reference is made to FIG. 1A, which is a backside view 11 of a back-contact photovoltaic cell 1, and simultaneously to FIG. 1B, which a cross-section of said back-contact photovoltaic cell 1 along the line A' in FIG. 1A. The back-contact photovoltaic cell 1 comprises an array of sections 10 logically organised in rows and columns. The back-contact photovoltaic cell 1 of the present example comprises four rows and four columns, the invention not being limited thereto. The sections 10 are typically integral with each other, together forming a single back-contact photovoltaic cell 1, so that the frontside 12 of the back-contact photovoltaic cell 1 forms a single, integral photosensitive surface. However, in some embodiments, the sections 10 may be electrically insulated from each other. Said sections 10 may be physically distinguishable from each other, but that is not necessary. FIG. 1A comprises white, dashed lines, and FIG. 1B comprises dotted lines 19, to indicate the separation or border between adjacent sections 10.

In the present example, the back-contact photovoltaic cell 1 is a metal wrap through type photovoltaic cell 1, comprising first contacts 21 (represented by the vertical stripes filling the sections 10) of a first polarity, electrically connected to the backside 11 of the back-contact photovoltaic cell 1. Alternatively, however, a different types of back-contract photovoltaic cell could be used, such as an interdigitated back contact photovoltaic cell.

In the present example, the first contacts 21 are conductors or backside fingers, running in parallel over the complete backside surface 11 of the back-contact photovoltaic cell 1. These first contacts 21 are typically for collecting charges of the first polarity from the photosensitive layer of the back-contact photovoltaic cell 1. Alternatively, different first contact configurations could be used, such as a configuration comprising or consisting of first contacts 21 in the form of contact pads or bonding pads, or, alternatively, a single first contact 21 covering a substantial portion of the backside surface 11.

In the present example, the back-contact photovoltaic cell 1 further comprises second contacts 22 of a second polarity, that are bonding pads electrically connected, via electrically conductive vias, to the frontside conductive grid (not shown) of the back-contact photovoltaic cell 1. Said vias penetrate from said frontside 12 through the back-contact photovoltaic cell 1 to the backside 11. The bonding pads 22 are, at the backside 11, electrically insulated from the first contacts 21. These second contacts 22 are typically for collecting charges of the second polarity, opposite to the first polarity, from the photosensitive layer of the back-contact photovoltaic cell 1. For example, the charges of the first polarity may be holes and the charges of the second polarity may be electrons, or the charges of the first polarity may be electrons and the charges of the second polarity may be holes.

The first contacts 21 and the second contacts 22 are arranged so that each section 10 comprises, at the backside 11 of the back-contact photovoltaic cell 1, at least one first contact 21 and at least one second contact 22. In the present example, each section 10 comprises a plurality of first contacts 21, and two second contacts 22.

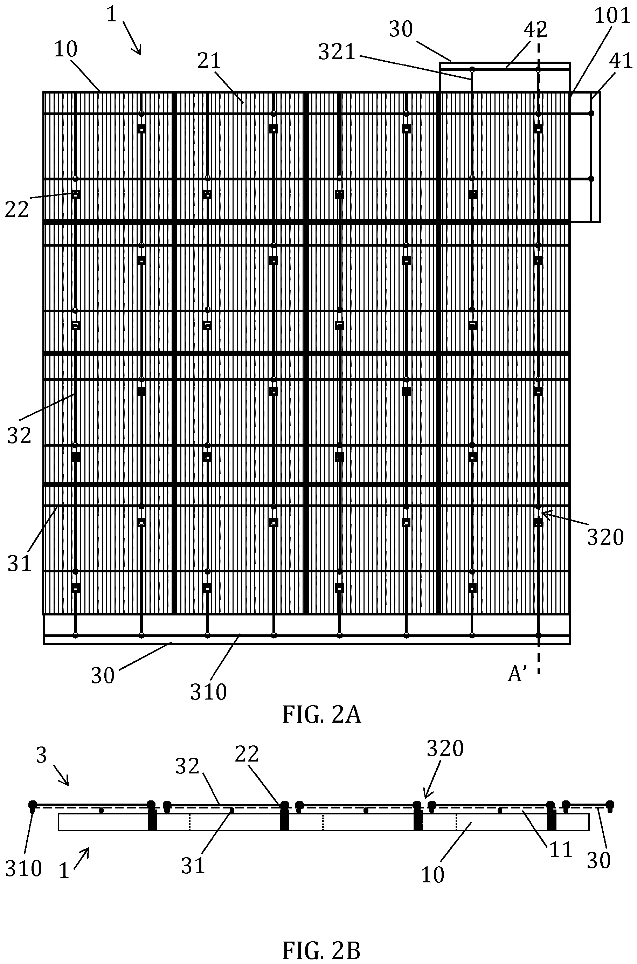

Reference is made to FIG. 2A, which is a top view of a backside 21 of a back-contact photovoltaic cell 1 after applying a cell-level interconnection sheet, and simultaneously to FIG. 2B, which a cross-section of said back-contact photovoltaic cell 1 along the line A' in FIG. 2A. The cell-level interconnection sheet 3 is attached to the backside 11 of the back-contact photovoltaic cell 1. In this example, the cell-level interconnection sheet 3 covers the complete backside of the back-contact photovoltaic cell 1, i.e., each of the sections 10 of the back-contact photovoltaic cell 1.
The cell-level interconnection sheet 3 is, typically, provided as a whole, so that applying the cell-level interconnection sheet 3 to the backside 11 of the back-contact photovoltaic cell 1 may be performed in a single step.

In the example illustrated, the cell-level interconnection sheet 3 comprises an insulating carrier sheet 30, formed of an electrically insulating material that is, in this example, optically transparent. Optical transparency may have the advantage that also the backside 11 of the back-contact photovoltaic cell 1 may collect light, which may be advantageous if the back-contact photovoltaic cell 1 is a bifacial back-contact photovoltaic cell 1.

The insulating carrier sheet 30 may comprise an electrically insulating polymer film, and an adhesive functionality on both sides thereof. The adhesive functionality may provide adhesion of the interconnects 31, 32 to the insulating carrier sheet 30. Furthermore, the adhesive functionality may provide adhesion of the insulating carrier sheet 30 to the backside 11 of the back-contact photovoltaic cell 1.

Alternatively, the insulating carrier sheet 30 may comprise or consist of an encapsulant sheet. In that case, the encapsulant sheet may be used during later lamination.

The insulating carrier sheet 30 may comprise three polymer layers, comprising a central, core layer (e.g., the electrically insulating polymer film), sandwiched between two skin layers, and having a higher melting point than said skin layers. In these embodiments, the insulating carrier sheet 30 may be heated to a temperature above the melting point of the skin layers, and below the melting point of the core layer. The skin layers may be melted before or while it is contacted to the backside 11 of the back-contact photovoltaic cell 1, and solidified (e.g., by cooling of the insulating carrier sheet 30 below the melting point of the skin layers) during said contacting, to provide adhesion of the insulating carrier sheet 30 to said backside 11, while the core layer (not being melted) may provide mechanical support to the insulating carrier sheet 30.

The invention is, however, not limited thereto and the adhesive functionality may be provided by any adhesive, typically an electrically insulating adhesive, that may be provided on opposite sides of the insulating carrier sheet 30.

The cell-level interconnection sheet 3 further comprises parallel interconnects 31 arranged to electrically couple, within each row of the array of sections 10, the first contacts 21 to each other. In this example, the cell-level interconnection sheet 3 comprises two parallel interconnects 31 for each section 10. In this example, the parallel interconnects 31 are located at a side of the insulating carrier sheet 30 facing the backside 11 of the back-contact photovoltaic cell 1, so that each parallel interconnect 31 runs over the complete width of the back-contact photovoltaic cell 1, electrically contacting each first contact 21 it overlays.

The cell-level interconnection sheet 3 further comprises serial interconnects 32, located at a side of the insulating carrier sheet 30 facing away from the backside 11 of the back-contact photovoltaic cell 1. Thus, in the example illustrated, the parallel interconnects 31 are located on a first side, attached or to be attached to the photovoltaic cell 1, of the interconnection sheet, and the serial interconnects 32 are extending on a second side, opposite to the first side, of the interconnection sheet 3. The serial interconnects 32 are arranged to electrically couple, within each column of the array, the parallel interconnect 31 connected to the first contacts 21 of each section (indicated by the dots at the ends of the serial interconnects 32), to the second contact 22 of an adjacent section 10. In this example, each serial interconnect 32 couples one of the two parallel interconnects 31 for a row to one of the two second contacts 22 of an adjacent row. Herein, a direction from the parallel interconnect 31 to the second contact 22, coupled to each other by the serial interconnect 32, is the same for each serial interconnect 32. For providing said electrical coupling, each serial interconnect 32 penetrates through the insulating carrier sheet 30 for contacting the parallel interconnect 31 and the second contact 22.

Each serial interconnect 32 is electrically interrupted (indicated by arrow 320) between the second contact 22 of each section 10 and the parallel interconnect 31 connected to the first contacts 21 of said section 10.

The present example provides a particularly advantageous arrangement for interconnecting back-contact photovoltaic cells 1 of the present invention, which will be described below, although the invention is not limited to this particular arrangement.

In the example illustrated, the interconnection sheet comprises a first lateral edge contact 41 at a corner cell section 101, located at a corner of the array, wherein the first lateral edge contact 41 extends off the cell sections 10, i.e., off the back-contact photovoltaic cell 1, or, in other words, does not overlap with the back-contact photovoltaic cell 1. The first lateral edge contact 41 is electrically coupled to a parallel interconnect 31 of the row containing said corner cell section 101.

In the example illustrated, the interconnection sheet further contains a second lateral edge contact 42 at said corner cell section 101, extending off the cell sections 10, i.e., off the back-contact photovoltaic cell 1. The second lateral edge contact 42 is electrically coupled to an interconnect 321 connected to the parallel interconnect 31 connected to the first contacts 21 of said corner cell section 101.

The first lateral edge contact 41 extends off the cell sections 10 in a direction along which each row is oriented, and the second lateral edge contact 42 extends off the cell sections 10 in a direction along which each column is oriented. The insulating carrier sheet 30 extends off the cell sections 10 as well at the locations of the first lateral edge contact 41 and the second lateral edge contact 42, for providing mechanical support to said contacts 41, 42.

The interconnection sheet 3 comprises a further parallel interconnect 310, oriented parallel to the parallel interconnects 31, on the first side of the interconnection sheet 3 facing the interconnecting back-contact photovoltaic cell 1. The further parallel interconnect 310 may form a third lateral edge contact, and, together with the insulating carrier sheet 30 to which it is bonded, extend off the cell sections 10, in a direction away from the first lateral edge contact 41 and the second lateral edge contact 42.

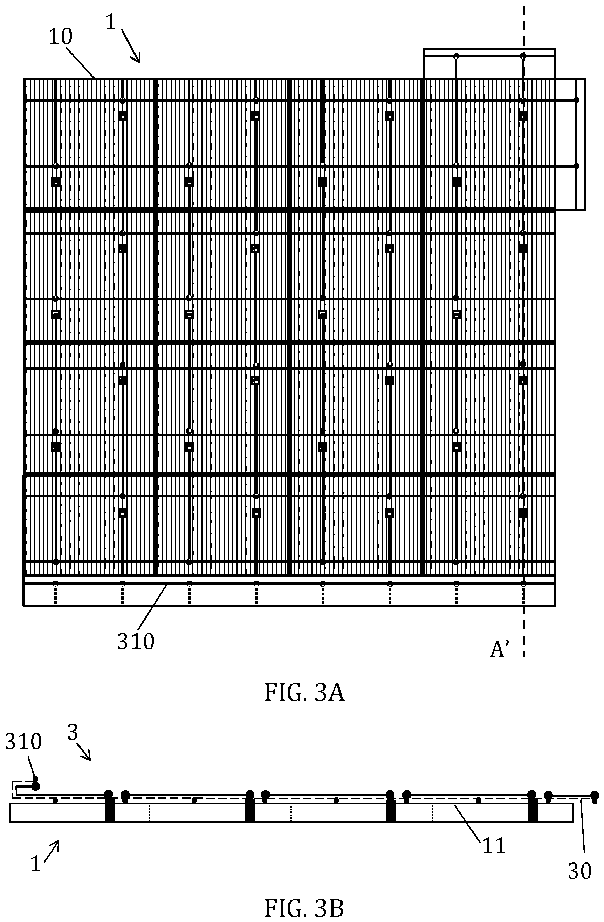

Reference is made to FIG. 3A, which is a top view of a backside 11 of the back-contact photovoltaic cell 1 comprising the cell-level interconnection sheet 3, and simultaneously to FIG. 3B, which a cross-section of said back-contact photovoltaic cell 1 along the line A' in FIG. 3A. The interconnection sheet 3 is folded back at the side containing the further parallel interconnect 310 extending off the sections 10, thereby exposing the further parallel interconnect 310. Thereby, the folded back part of the interconnection sheet 3 now faces away from the back-contact photovoltaic cell 1, facilitating further electrical connections with other back-contact photovoltaic cells 1, as will be described further below. For clarity, in FIG. 3A, the folded back part of the insulating carrier sheet 30 is shown as a non-transparent part.

Subsequently, after application of the cell-level interconnection sheet 3, the photovoltaic cell 1 may be partitioned into a plurality of physically separated but electrically interconnected cell pieces, so that the cell pieces in each row are connected in parallel by the parallel interconnects 31, and the cell pieces in each column are interconnected in series by the serial interconnects 32. This may be performed by any technique known by the skilled person.

Below, a particularly preferred technique is explained.

### Example 2: Partitioning a back-contact photovoltaic cell

This example explains a particular embodiment of partitioning the cell, although the invention is not limited to this example. In this example, the cell-level interconnection sheet is first placed on a vacuum mold, before attaching it to the backside of the back-contact photovoltaic cell as explained in Example 1.

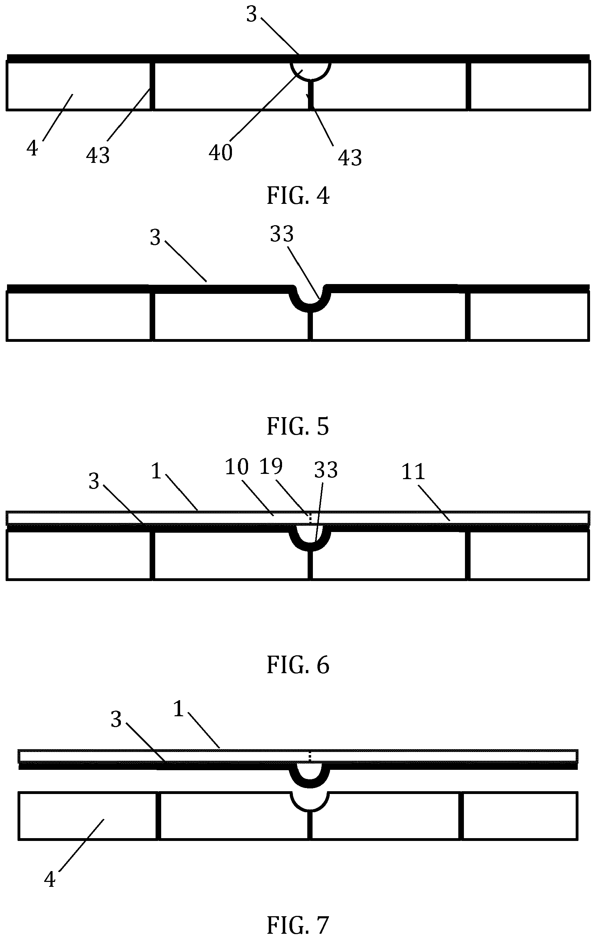

FIG. 4 shows a vertical cross-section of part of such a vacuum mold 4, comprising a trench 40, and a cell-level interconnection sheet 3 (comprising interconnects that are not shown for simplicity), positioned on the vacuum mold 4. The mold 4 comprises a plurality of channels 43 - one of which is, in the example illustrated, fluidically coupled to the trench 40 - to which a vacuum may be applied.

FIG. 5 shows the vacuum mold 4 on which the cell-level interconnection sheet 3 is positioned after applying a vacuum into the trenches 40 to form corresponding deformations 33 into the cell-level interconnection sheet 3, corresponding to the shape of the trench 40, thereby forming a preformed cell-level interconnection sheet 3.

Subsequently, the back-contact photovoltaic cell 1 is positioned onto, and attached to, the cell-level interconnection sheet 3, as shown in FIG. 6, wherein the backside 11 of the back-contact photovoltaic cell 1 contacts the cell-level interconnection sheet 3. This step may be performed similarly as described in Example 1. The photovoltaic cell 1 is attached to the preformed cell-level interconnection sheet 3 so that said deformations 33 in the cell-level interconnection sheet 3 are located between adjacent sections 10 of the photovoltaic cell 1. Indeed, the dotted line 19 (shown in FIG. 6 as well as in FIG. 1B), corresponding to a separation or border between adjacent sections 10, is located at the deformation 33.

After attachment of the photovoltaic cell 1 to the preformed cell-level interconnection sheet 3, the photovoltaic cell 1 with the preformed cell-level interconnection sheet 3 may be removed (e.g., after removing the vacuum) from the vacuum mold 4 as shown in FIG. 7.

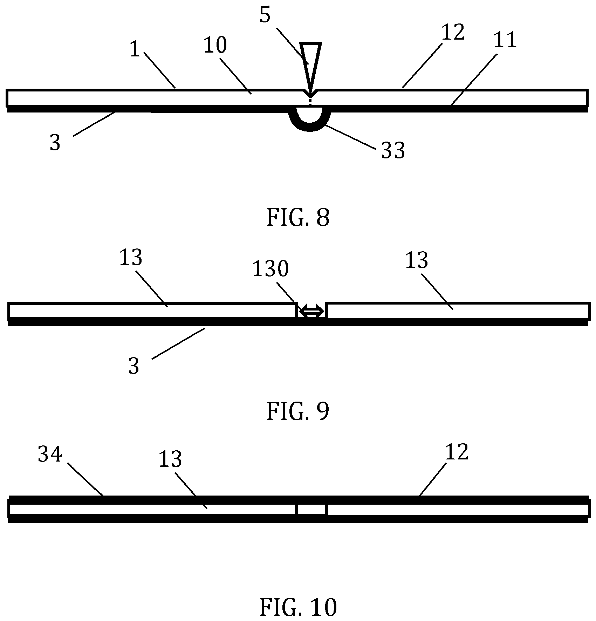

Reference is made to FIG. 8. The sections 10 of the photovoltaic cell 1 are split at the deformations 33 in the preformed cell-level interconnection sheet 3 so as to partition the sections 10 from each other. Said splitting may be formed using, for example, scribing using a laser beam 5 or a saw. In the example illustrated, said scribing is performed from a frontside 12 of the photovoltaic cell 1, so that the cell-level interconnection sheet 3 attached to the backside 11 of the photovoltaic cell 1 may remain intact and is not scribed.

Reference is made to FIG. 9. Indeed, typically, only the photovoltaic cell 1 is scribed so that the sections 10 of the photovoltaic cell 1 become physically separated from each other, thereby forming cell pieces 13 corresponding to the sections 10 after said partitioning. After partitioning, the cell-level interconnection sheet 3 supports and physically interconnects the cell pieces 13. Herein, the deformation is flattened by, after said partitioning, stretching the cell-level interconnection sheet 3 at the deformations, e.g., by laterally moving the cell pieces 13 away from each other (as indicated by the double arrow). Thereby, the cell pieces 13 may be separated from each other so that direct physical and electrical contact is prevented, which may prevent short-circuits between different cell pieces 13. The cell pieces 13 may be separated at a predetermined distance from each other, which may result in a predictable curving functionality. Furthermore, the degree of partial transparency of the photovoltaic device may be tuned by tuning the dimensions of the deformation 33, and, thus, the size of the gap between adjacent cell pieces 13, which may be beneficial for bifacial photovoltaic devices. Electrical contact between the cell pieces 13 is provided via the cell-level interconnection sheet 3.

Reference is made to FIG. 10. Finally, a transparent sheet 34 is attached to a frontside 12 of the plurality of cell pieces 13. Said transparent sheet 34 may provide further mechanical support to the plurality of cell pieces 13.

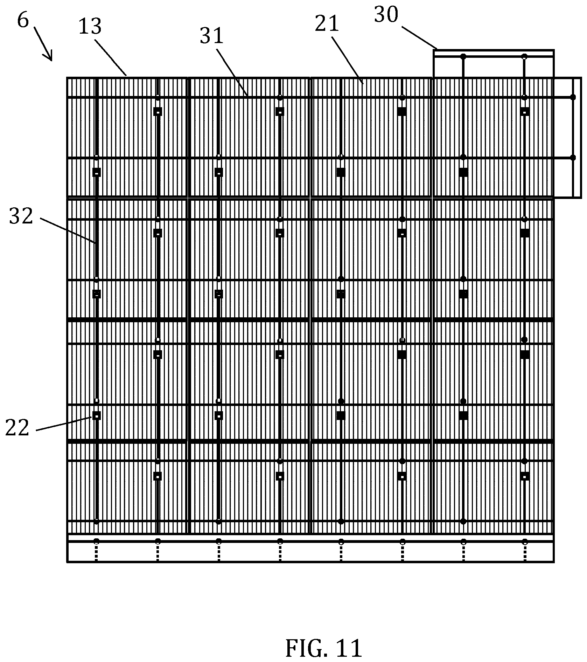

Reference is made to FIG. 11, which corresponds to the photovoltaic cell 1 of FIG. 3A after the partitioning as described above, and which corresponds to a photovoltaic device 6 comprising a plurality of electrically interconnected back-contact photovoltaic cell pieces 13 in accordance with embodiments of the present invention. An interconnection sheet, attached to the backside of the array of photovoltaic cell pieces 13, comprises an insulating carrier sheet 30 for supporting the array of cell pieces 13. The interconnection sheet further comprises a plurality of conductive wires 31, 32, comprising parallel interconnects 31 arranged to electrically couple, within each row of the array, the first contacts 21 to each other, so that the cell pieces 13 in each row are connected in parallel by the parallel interconnects 31. The interconnection sheet further comprises serial interconnects 32 arranged to electrically couple, within each column of the array, for each pair of adjacent cell pieces 13, the parallel interconnect 31 connected to the first contacts 21 of a cell piece 13 of the pair to the second contact 22 of an adjacent cell piece 13 of the pair, wherein each serial interconnect 32 is electrically interrupted between the second contact 22 of each cell piece 13 and the parallel interconnect 31 connected to the first contacts 21 of said cell piece 13, so that the cell pieces 13 in each column are interconnected in series by the serial interconnects 32.

Having an array of photovoltaic cell pieces 13 instead of a single, large photovoltaic cell may reduce the current and voltage to be transported through a single wire, so that less conductive material (such as metal) may be required, and also back-illumination may be more efficient as smaller wires block less solar irradiation. Indeed, lower currents that are possible in embodiments of the present invention allow reduction of interconnection cost. Furthermore, the combination of parallel interconnects 31 and serial interconnects 32 provides increased flexibility with respect to shading tolerance, which may be problematic in the state of the art.

In a third aspect, the present invention relates to a photovoltaic module comprising a plurality of photovoltaic devices in accordance with to embodiments of the second aspect of the present invention.

### Example 3: A photovoltaic module

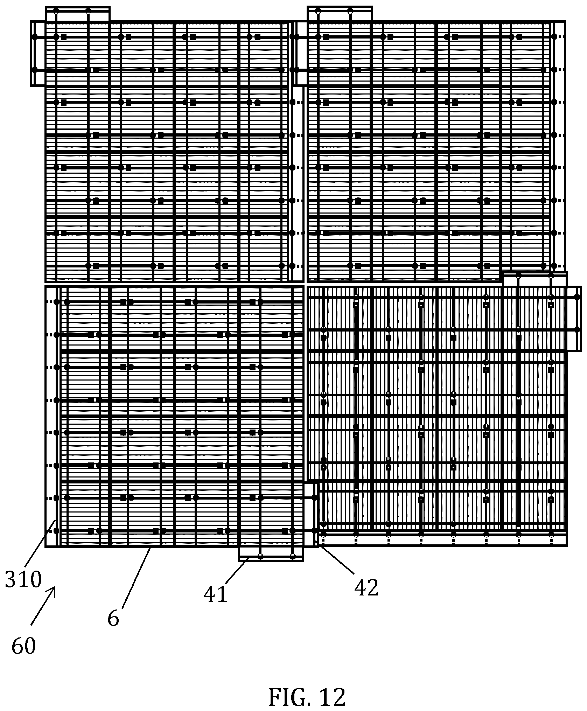

Reference is made to FIG. 12. The photovoltaic devices 6 of Example 2 may be interconnected, by electrically connecting the further parallel interconnect 310 of a photovoltaic device 6 to the first lateral edge contact 41 or the second lateral edge contact 42 of another photovoltaic device 6 to form a photovoltaic module 60 in accordance with embodiments of the present invention. The cell-level interconnection sheet of Examples 1 and 2 above facilitate said electrical connection, as the further parallel interconnect 310 of the photovoltaic device 6 may directly contact the first lateral edge contact 41 or the second lateral edge contact 42 of the other photovoltaic device 6.

In the configuration of the exemplary module 60 shown in FIG. 12, the photovoltaic devices 6 are interconnected in series, but a different configuration may be selected so that the photovoltaic devices 6 may be interconnected in a combination of serial and parallel interconnections. It is an advantage of embodiments of the present invention that good flexibility may be achieved for interconnecting the photovoltaic devices 6.

It is an advantage of embodiments of the present invention that a higher number of cell pieces 13, or smaller cell pieces 13, per device 6, may allow for more curved modules 60.

### Example 4: interdigitated back-contact-type photovoltaic cell module

In the above examples, the back-contact photovoltaic cell is a metal wrap through-type photovoltaic cell. However, the invention is not limited thereto. Instead, the back-contact photovoltaic cell may be an interdigitated back-contact photovoltaic cell. In the latter case, there is typically no metallization on the frontside.

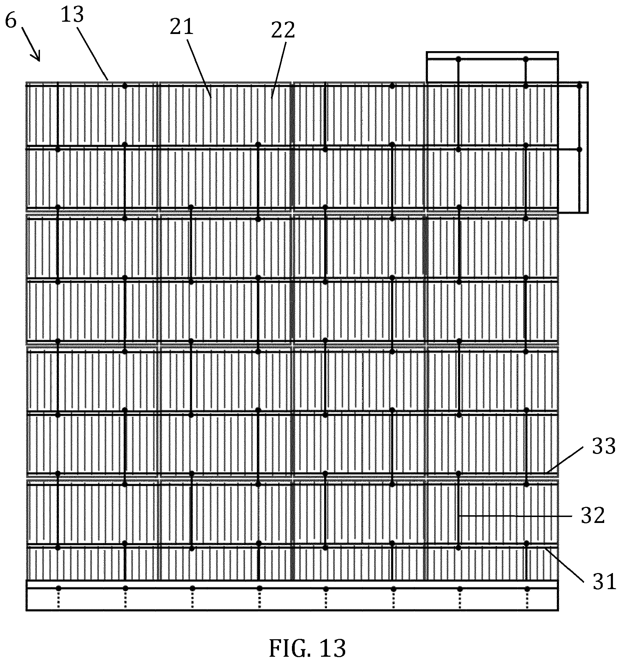

Reference is made to FIG. 13, which is a backside view of a photovoltaic device 6 comprising interdigitated back contact photovoltaic cell pieces. The photovoltaic device 6 comprises, as well, an array of physically separated back-contact photovoltaic cell pieces 13 logically organised in rows and columns - in the example illustrated, four rows and four columns. Each photovoltaic cell piece 13 comprises, at a backside thereof, at least one first contact 21 of a first polarity and at least one second contact 22 of a second polarity, opposite to the first polarity. An interconnection sheet, attached to said backside of the array of photovoltaic cell pieces 13, comprises an insulating carrier sheet for supporting the array of cell pieces.

The interconnection sheet further comprises a plurality of conductive wires 31, 32, 33. The conductive wires comprise parallel interconnects 31 arranged to electrically couple, within each row of the array, the first contacts 21 to each other, so that the first contacts 21 of the cell pieces 13 in each row are connected in parallel by the parallel interconnects 31.

In the example illustrated, the conductive wires comprise additional parallel interconnects 33 arranged to electrically couple, within each row of the array, the second contacts 22 to each other, so that the second contacts 22 of the cell pieces 13 in each row are connected in parallel by the additional parallel interconnects 33.

The conductive wires further comprise serial interconnects 32 arranged to electrically couple, within each column of the array, for each pair of adjacent pieces 13, the parallel interconnect 31 connected to the first contact 21 of a cell piece 13 of the pair to the second contact 22 of an adjacent cell piece 13 of the pair, via the additional parallel interconnects 33. Each serial interconnect 32 is electrically interrupted between the second contact 22 of each cell piece 13 and the parallel interconnect 31 connected to the first contacts 21 of said cell piece 13, so that the cell pieces 13 in each column are interconnected in series by the serial interconnects 32.

It is to be understood that although preferred embodiments, specific constructions and configurations, as well as materials, have been discussed herein for devices according to the present invention, various changes or modifications in form and detail may be made without departing from the scope of this invention. Steps may be added or deleted to methods described within the scope of the present invention.

## Claims

1. A method of forming a photovoltaic device (6) comprising a plurality of electrically interconnected back-contact photovoltaic cell pieces (13), the method comprising:
i) obtaining a back-contact photovoltaic cell (1) comprising an array of sections (10) logically organised in rows and columns, each section (10) comprising, at a backside (11) of the cell (1), at least one first contact (21) of a first polarity and at least one second contact (22) of a second polarity, opposite to the first polarity,
ii) attaching, to said backside (11), a cell-level interconnection sheet (3) comprising:
an insulating carrier sheet (30), and
a plurality of conductive wires (31, 32), comprising:
parallel interconnects (31) arranged to electrically couple, within each row of the array, the first contacts (21) to each other, and
serial interconnects (32) arranged to electrically couple, within each column of the array, for each pair of adjacent sections (10), the parallel interconnect (31) connected to the first contact (21) of a section (10) of the pair to the second contact (22) of an adjacent section (10) of the pair, wherein each serial interconnect (32) is electrically interrupted between the second contact (22) of each section (10) and the parallel interconnect (32) connected to the first contacts (21) of said section (10), and
iii) partitioning the photovoltaic cell (1) into a plurality of physically separated cell pieces (13),
wherein said attaching and said partitioning are performed so that the cell pieces (13) in each row are connected in parallel by the parallel interconnects (31), and the cell pieces (13) in each column are interconnected in series by the serial interconnects (32).

2. The method of claim 1, wherein partitioning the photovoltaic cell (1) comprises cutting, from a frontside (12) of the cell (1), the photovoltaic cell (1) so as to physically separate the sections (10) from each other, thereby obtaining an array of back-contact photovoltaic cell pieces (13).

3. The method of any of claims 1 or 2, further comprising a step iv) of:
iv) attaching a transparent sheet (34) to a frontside (12) of the plurality of cell pieces (13).

4. The method of any of the previous claims, wherein step iii) is performed after step ii), comprising a step ii') before step ii), of:
ii') preforming the cell-level interconnection sheet (3) by positioning the cell-level interconnection sheet (3) on a vacuum mold (4) comprising a plurality of trenches (40), and applying a vacuum into the trenches (40) to form corresponding deformations (33) into the cell-level interconnection sheet (3),
wherein, in step ii), the photovoltaic cell (1) is attached to the preformed cell-level interconnection sheet (3) so that said deformations (33) in the cell-level interconnection sheet (3) are located between adjacent sections (10) of the photovoltaic cell (1),
wherein, in step iii), after step ii), the sections (10) are split at the deformations (33) in the preformed cell-level interconnection sheet (3).

5. The method of any of claims 2 to 4, wherein said cutting is performed by laser scribing.

6. A photovoltaic device (6) comprising:
an array of physically separated back-contact photovoltaic cell pieces (13) logically organised in rows and columns, each photovoltaic cell piece (13) comprising, at a backside (11) thereof, at least one first contact (21) of a first polarity and at least one second contact (22) of a second polarity, opposite to the first polarity,
an interconnection sheet (3), attached to said backside (11) of the array of photovoltaic cell pieces (13), comprising:
an insulating carrier sheet (30) for supporting the array of cell pieces, and
a plurality of conductive wires (31, 32), comprising:
parallel interconnects (31) arranged to electrically couple, within each row of the array, the first contacts (21) to each other, so that the cell pieces (13) in each row are connected in parallel by the parallel interconnects (31), and
serial interconnects (32) arranged to electrically couple, within each column of the array, for each pair of adjacent pieces (13), the parallel interconnect (31) connected to the first contact (21) of a cell piece (13) of the pair to the second contact (22) of an adjacent cell piece (13) of the pair, wherein each serial interconnect (32) is electrically interrupted between the second contact (22) of each cell piece (13) and the parallel interconnect (31) connected to the first contacts (21) of said cell piece (13), so that the cell pieces (13) in each column are interconnected in series by the serial interconnects (32).

7. The photovoltaic device (6) of claim 6, wherein the interconnection sheet (3) comprises a first lateral edge contact (41) at a corner cell piece, located at a corner of the array, wherein the first lateral edge contact (41) extends off the cell pieces (13),
wherein the first lateral edge contact (41) is electrically coupled to a parallel interconnect (31) of the row containing said corner cell piece.

8. The photovoltaic device (6) of claim 7, wherein the interconnection sheet (3) contains a second lateral edge contact (42) at said corner cell piece, extending off the cell pieces (13), and electrically coupled to an interconnect (320) connected to the parallel interconnect (31) connected to the first contacts (21) of said corner cell piece,
wherein the first lateral edge contact (41) extends off the cell pieces (13) in a direction along which each row is oriented, and wherein the second lateral edge contact (42) extends off the cell pieces (13) in a direction along which each column is oriented.

9. The photovoltaic device (6) of any of claims 7 or 8,
wherein the parallel interconnects (31) are extending on a first side, attached to the photovoltaic cell pieces (13), of the interconnection sheet (3), and the serial interconnects (32) are extending on a second side, opposite to the first side, of the interconnection sheet (3),
wherein the interconnection sheet (3) comprises a further parallel interconnect (310), oriented parallel to the parallel interconnects (31), on the first side of the interconnection sheet (3),
wherein the interconnection sheet (3) is folded back at a first edge of the photovoltaic device (6) different from a second edge containing a lateral edge contact (41, 42), thereby exposing the further parallel interconnect (310) for making further electrical connections.

10. The photovoltaic device (6) of any of claims 6 to 9, wherein the back-contact photovoltaic cell pieces (13) are metal wrap through type photovoltaic cell pieces or interdigitated back contact photovoltaic cell pieces.

11. The photovoltaic device (6) of any of claims 6 to 10, wherein the back-contact photovoltaic cell pieces (13) are 2-terminal tandem photovoltaic cell pieces.

12. The photovoltaic device (6) of any of claims 6 to 11, wherein the insulating carrier sheet (30) comprises an electrically insulating polymer film with an adhesive functionality on both sides.

13. A photovoltaic module (60) comprising a plurality of photovoltaic devices (6) according to any of claims 6 to 12.
